# EUROPEAN PATENT APPLICATION

(11) **EP 4 716 425 A1**
(43) Date of publication of application: **25.03.2026**
(21) Application number: 25202370.0
(22) Date of filing: 16.09.2025
(51) Int. Cl.: H10H 20/819, H10H 20/831, H10H 20/84, H10H 20/851

(54) **WAVELENGTH-CONVERTED LIGHT-EMITTING DIODES WITH FLIP CHIP GEOMETRY**

(30) Priority: 19.09.2024 US 202418890531
(71) Applicant: Lumileds Singapore Pte. Ltd., Singapore 768925 (SG)
(72) Inventor: DiMaria, Jeff, Scotts Valley (CA); Lopez-Julia, Antonio, Vaals (NL); Shen, Yu-Chen, Sunnyvale (CA); Flemish, Joseph, San Jose (CA)
(74) Representative: Cohausz & Florack

(57) **Abstract**

An LED includes first/second doped layers with active region(s) therebetween emitting a first wavelength, and is arranged in a flip chip geometry with reflective layer(s) on a first LED surface. A wavelength converter facing a second LED surface absorbs the first wavelength and emits a second, longer wavelength. In some examples, the wavelength converter is on the LED surface and angled sidewalls. In some other examples, the wavelength converter is on the surface and angled sidewalls of a dielectric medium on the second LED surface. In still other examples, the LED can include on the first LED surface a mesa with the active region(s) and one of the doped layers, with angled LED and mesa sidewalls. The wavelength converter is on the LED surface and reflective layer(s) are on the LED sidewalls.

## Description

### FIELD OF THE INVENTION

The field of the present invention relates to light-emitting diodes (LEDs). Wavelength-converted LEDs are described herein having a flip chip geometry.

### BACKGROUND

Semiconductor light emitting diodes and laser diodes (collectively referred to herein as "LEDs") are among the most efficient light sources currently available. The emission spectrum of an LED typically exhibits a single narrow peak at a wavelength determined by the structure of the device and by the composition of the semiconductor materials from which it is constructed. By suitable choice of device structure and material system, LEDs may be designed to operate at ultraviolet, visible, or infrared wavelengths.

In some instances the light directly emitted by the active region of an LED can comprise its entire output; such an LED can be referred to as a direct emitter, or a direct-emitting LED. The LEDs of the present disclosure are combined with one or more wavelength-converting materials (also referred to herein as "phosphors") that absorb light emitted by the LED active region and in response emit light of a longer wavelength. Hereinafter the term LED shall denote such wavelength-converted LEDs, unless explicitly stated otherwise. For wavelength-converted LEDs (sometimes referred to as phosphor-converted LEDs), the fraction of the light emitted by the LED active region that is absorbed by the phosphors depends on the amount of phosphor material in the optical path of the light emitted by the LED active region, for example on the concentration of phosphor material in a phosphor layer disposed on or around the LED and the thickness of the layer. Wavelength-converted LEDs can be designed so that all of the light emitted by the LED active region is absorbed by one or more phosphors, in which case the overall output of the wavelength-converted LED is entirely from the one or more phosphors. In such cases one or more phosphors can be selected, for example, to emit light in one or more corresponding narrow spectral regions that are not efficiently generated directly by the LED active region, or to emit white light having a desired color temperature or desired color-rendering properties. Alternatively, wavelength-converted LEDs can be designed so that only a portion of the light emitted by the LED active region is absorbed by the phosphor(s), in which case the emission from the wavelength-converted LED is a mixture of light emitted by the LED active region and light emitted by the phosphor(s). By suitable choice of LED, phosphor(s), and phosphor composition, such a wavelength-converted LED can be designed to emit, for example, white light having a desired color temperature or desired color-rendering properties.

Multiple LEDs can be formed together on a single substrate to form an array. Such arrays can be employed to form active illuminated displays, such as those employed in, e.g., smartphones and smart watches, computer or video displays, augmented- or virtual-reality displays (i.e., visualization systems), or signage, or to form adaptive illumination sources, such as those employed in, e.g., automotive headlights, street lighting, camera flash sources, or flashlights (i.e., torches). An array having one or several or many individual devices per millimeter (e.g., device pitch or spacing of about a millimeter, a few hundred microns, less than 50 or 100 microns, or even smaller, and/or separation between adjacent devices less than 100 microns or only a few tens of microns or even less) typically is referred to as a miniLED array or a microLED array (alternatively, a µLED array).

### SUMMARY

A wavelength-converted light-emitting device includes a semiconductor light-emitting diode (LED), a wavelength converter, first and second electrical contacts and contact pads, and one or more first insulating layers. The LED includes first and second doped layers with one or more active regions between them. The active region(s) emit first output light in a first output wavelength range. The first doped layer is between a first LED surface and the active region(s); the second doped layer is between a second LED surface and the active region(s). LED sidewalls connect the first and second LED surfaces. The wavelength converter is positioned on at least the second LED surface and absorbs at least a portion of the first output light that enters the wavelength converter and emits second output light in a second output wavelength range that is longer than the first output wavelength range.

In a first set of examples the LED sidewalls form an angle less than about 70° with either the first or second LED surface, and the wavelength converter is positioned on the second LED surface and the LED sidewalls. The first electrical contact, on the first LED surface, includes a metallic layer, a first electrically insulating layer between the metallic layer and LED, and electrically conductive vias through the first insulating layer that connect the metallic layer to the first doped layer. A second electrically insulating layer is positioned on the metallic layer with the first contact between the second insulating layer and the LED. A second electrical contact is in direct electrical contact with the second doped layer on at least a portion of the LED sidewalls and is electrically isolated from the active layers, first doped layer, and first contact by the second insulating layer. First and second electrical contact pads are positioned on the second insulating layer with the second insulating layer between the contact pads and the metallic layer. Electrically conductive vias through the second insulating layer connect the first contact pad to the metallic layer; the second contact pad is connected to the second contact.

A second set of examples can be arranged in a manner generally similar to the first set, with the addition of a dielectric medium between the second LED surface and the wavelength converter. Sidewalls of the dielectric medium form an angle less than about 70° with one of the surfaces of the dielectric medium. The wavelength converter is positioned on the second dielectric surface and on the dielectric sidewalls.

In a third set of examples the LED sidewalls form an angle greater than about 110° with the first LED surface, and the LED includes a central mesa protruding from the first LED surface. The mesa has a mesa surface and mesa sidewalls that connect the mesa surface to the first LED surface and form an angle greater than about 110° with the mesa surface. The active region(s) span the central mesa, the first doped semiconductor layer is between the mesa surface and the active region(s), and the second doped layer is between the second LED surface and the active region(s) and between the first and second LED surfaces. A first electrically insulating layer is on the LED sidewalls, the first LED surface, the mesa sidewalls, and the mesa surface. A transparent conductive oxide (TCO) layer is between the first insulating layer and the mesa surface and in direct contact with the first doped layer; a first metallic layer is on portions of the first insulating layer and connected to the TCO layer by a first set of one or more electrically conductive vias through the first insulating layer. A second metallic layer is on portions of the first insulating layer, electrically isolated from the first metallic layer, and connected to the second doped layer at the first LED surface by a second set of one or more electrically conductive vias through the first insulating layer. Respective portions of the first and second metallic layers are arranged as corresponding first and second contact pads.

Objects and advantages pertaining to wavelength-converted LEDs may become apparent upon referring to the example embodiments illustrated in the drawings and disclosed in the following written description or appended claims.

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

### BRIEF DESCRIPTION OF THE DRAWINGS

Fig. 1 shows a schematic cross-sectional view of an example wavelength-converted LED.
Figs 2A and 2B show, respectively, cross-sectional and top schematic views of an example array of LEDs.
Fig. 3 is a top schematic view of an example LED array and an enlarged section of 3x3 LEDs of the array.
Figs. 4 through 6 are schematic cross-sectional views of three examples among a first set of examples of a wavelength-converted LED.
Figs. 7 through 9 are schematic cross-sectional views of three examples among a second set of examples of a wavelength-converted LED.
Figs. 10 and 11 are schematic cross-sectional views of two examples among a third set of examples of a wavelength-converted LED.

The embodiments depicted are shown only schematically; all features may not be shown in full detail or in proper proportion; for clarity certain features or structures may be exaggerated or diminished relative to others or omitted entirely (e.g., exaggerated thicknesses of optical coatings or transparent conductive layers); the drawings should not be regarded as being to scale unless explicitly indicated as being to scale. In the drawings some schematic illustrations of example structures of various devices and assemblies described herein may be shown with precise right angles and straight lines, but it is to be understood that such schematic illustrations may not reflect real-life process limitations or defects. Such process limitations or defects can cause the features to look not so "ideal" when any of the structures described herein are examined using, e.g., scanning electron microscopy (SEM) images or transmission electron microscope (TEM) images. In such images of real structures, possible processing limitations or defects might be visible, e.g., not-perfectly straight edges of materials, tapered vias or other openings, inadvertent rounding of corners or variations in thicknesses of different material layers. There may be other limitations or defects not listed here that can occur within the field of device fabrication. The embodiments shown are only examples and should not be construed as limiting the scope of the present disclosure or appended claims.

### DETAILED DESCRIPTION

The following detailed description should be read with reference to the drawings, in which identical reference numbers refer to like elements throughout the different figures. The drawings, which are not necessarily to scale, depict selective examples and are not intended to limit the scope of the inventive subject matter. The detailed description illustrates by way of example, not by way of limitation, the principles of the inventive subject matter.

For purposes of the present disclosure and appended claims, any arrangement of a layer, surface, substrate, diode structure, wavelength converter, or other structure "on," "over," or "against" another such structure shall encompass arrangements with direct contact between the two structures as well as arrangements including some intervening structure between them. Conversely, any arrangement of a layer, surface, substrate, diode structure, or other structure "directly on," "directly over," or "directly against" another such structure shall encompass only arrangements with direct contact between the two structures. For purposes of the present disclosure and appended claims, a layer, coating, structure, or material described as "transparent" or "substantially transparent" shall exhibit, over one or more pertinent wavelength ranges, a level of optical transmission that is sufficiently high, or a level of optical loss (due to absorption, scattering, reflection, or other loss mechanism) that is sufficiently low, that the light-emitting device can function within operationally acceptable parameters (e.g., output power or luminance, conversion or extraction efficiency, or other figures-of-merit including any described below). Similarly, a layer, coating, structure, or material described as "reflective" shall exhibit reflectivity that is sufficiently high, over one or more pertinent wavelength ranges, that the light-emitting device can function within operationally acceptable parameters such as those listed above or described below.

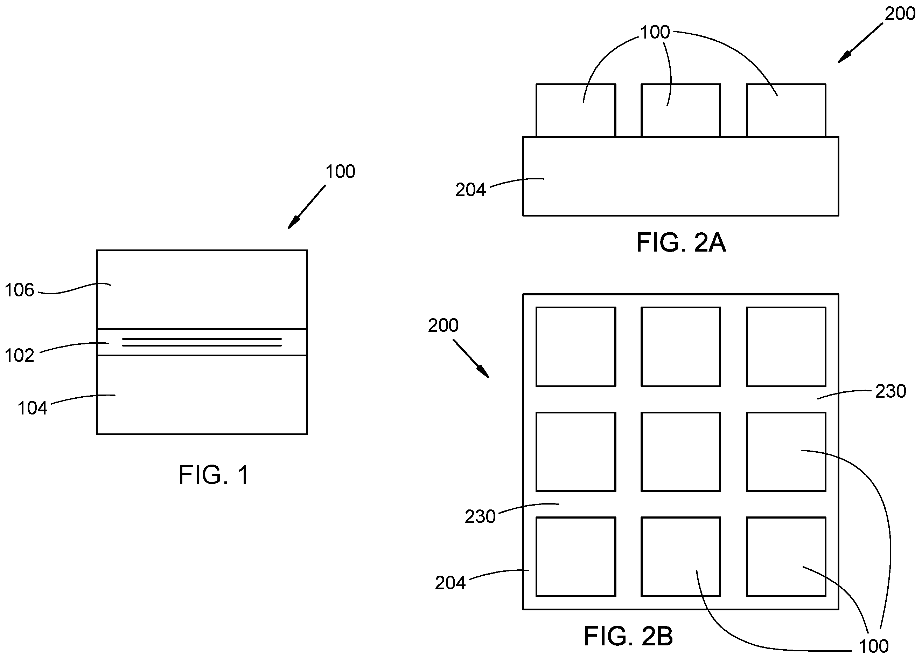

Fig. 1 shows an example of an individual wavelength-converted LED 100 comprising a semiconductor diode structure 102 (i.e., LED 102) disposed on a substrate 104 and a wavelength converter 106 (e.g., a phosphor layer) disposed on the LED 102. In the present disclosure "wavelength-converted LED 100" or simply "LED 100" shall denote a wavelength-converted LED generally arranged as in Fig. 1 (including both the LED 102 and the wavelength converter 106), while "semiconductor LED 102" or simply "LED 102" shall denote only the semiconductor diode structure 102 (without the wavelength converter 106). The semiconductor LED 102 typically comprises an active region disposed between n-type and p-type doped semiconductor layers; examples of an active region can include a junction between the n- and p-type layers, or one or more active layers between the n- and p-type layers (e.g., quantum well, multi-quantum well, quantum dots, and so forth). Application of a suitable forward bias across the LED 102 results in emission of first output light from the active region in a first output wavelength range. The wavelength of the emitted first output light is determined by the composition and structure of the active region and composition of the doped layers.

The LED 102 can be, for example, a III-Nitride LED that emits red, green, blue, violet, or ultraviolet light from its active region. Diode structures formed from any other suitable material system and that emit any other suitable wavelength of light can be employed. Other suitable material systems can include, e.g., III-Phosphide materials, III-Arsenide materials, other binary, ternary, or quaternary mixtures, compounds, or alloys of gallium, aluminum, indium, nitrogen, phosphorus, arsenic, or other III-V materials, or II-VI materials, or Group IV materials.

Any suitable wavelength-converting materials may be used for or incorporated into the wavelength converter 106, depending on the desired optical output from the wavelength-converted LED 100. Some examples can include, e.g., suitably doped ceramics, phosphor particles embedded in a suitable matrix material (e.g., a silicone or other polymer), or quantum dots. The wavelength converter 106 absorbs at least a portion of the first output light that enters the wavelength converter and emits second output light in a second output wavelength range that is longer than the first output wavelength range

Figs. 2A and 2B show, respectively, cross-sectional and top views of an array 200 of LEDs 100 disposed on a substrate 204. Such an array can include any suitable number of LEDs arranged in any suitable manner. In the illustrated example the array is depicted as being formed monolithically on a shared substrate; alternatively, an array of LEDs can be formed from separate individual LEDs (e.g., singulated devices that are assembled onto an array substrate). In an array of wavelength-converted LEDS, individual wavelength-converting pixels 106 can be positioned on each semiconductor diode pixel 102; alternatively, a continuous layer of wavelength-converting material can be disposed across multiple semiconductor LEDs 102. LEDs 100 in the array 200 may be spaced apart from each other by streets, lanes, or trenches 230. Arrays of the present disclosure can include light barriers (e.g., reflective, scattering, and/or absorbing) in the lanes 230 between adjacent LEDs 102, wavelength converters 106, or both; those light barriers can in some instances include one or more electrodes, metal layers, dielectric layers, multilayer coatings, and so forth on sidewalls of the LEDs. Some examples of those are described below.

Individual LEDs 100 of an array 200 can optionally incorporate or be arranged in combination with a lens or other optical element located adjacent to or disposed on the LED or wavelength converter. Such an optical element (not shown in the drawings) can be referred to as a "primary optical element". Instead or in addition, an LED array 200 (for example, mounted on an electronics board) can be arranged in combination with secondary optical elements such as waveguides, lenses, or both (not shown in the drawings) for use in an intended application. Other primary or secondary optical elements of any suitable type or arrangement can be included for each pixel or for an array of pixels, as needed or desired, depending on the desired application (e.g., display, illumination source, and so forth).

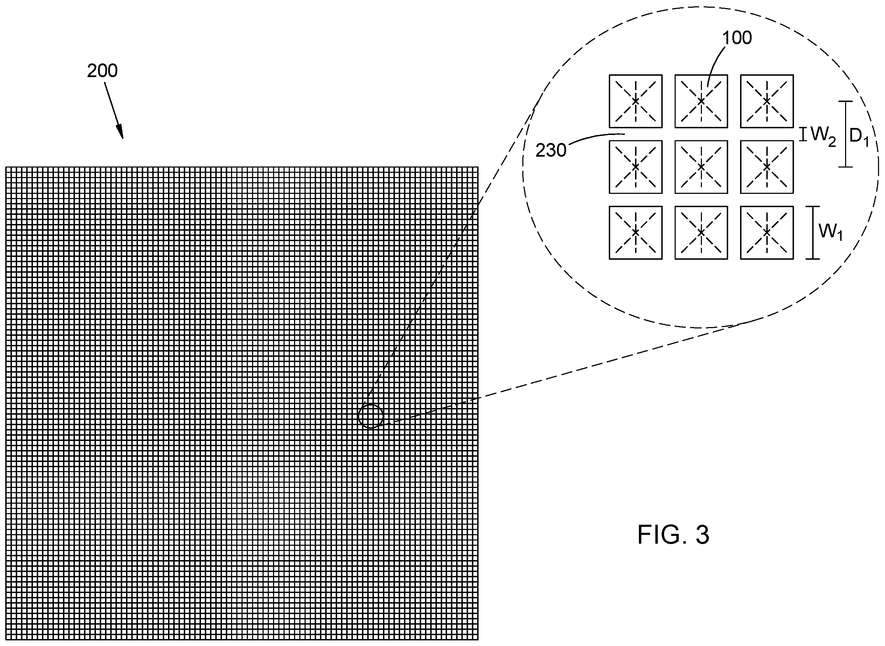

Although Figs. 2A and 2B show a 3x3 array of nine LEDs, LED arrays can include for example on the order of 10¹, 10², 10³, 10⁴, or more LEDs, e.g., as illustrated schematically in Fig. 3. In some examples individual LEDs 100 (i.e., pixels) may have widths w₁ (e.g., side lengths) in the plane of the array 200, for example, less than or equal to 1 millimeter (mm), less than or equal to 500 microns, less than or equal to 100 microns, or less than or equal to 50 microns. LEDs 100 in the array 200 may be spaced apart from each other by the streets, lanes, or trenches 230 having a width w₂ in the plane of the array 200 of, for example, hundreds of microns, less than or equal to 100 microns, less than or equal to 50 microns, less than or equal to 20 microns, less than or equal to 10 microns, or less than or equal to 5 microns. The pixel pitch or spacing D₁ is the sum of w₁ and w₂. LEDs having dimensions w₁ in the plane of the array (e.g., side lengths) of less than or equal to about 200 microns are typically referred to as microLEDs or µLEDs, and an array of such microLEDs may be referred to as a microLED array. LEDs having dimensions w₁ in the plane of the array (e.g., side lengths) of between about 0.10 millimeters and about 1.0 millimeters are typically referred to as miniLEDs, and an array of such miniLEDs may be referred to as a miniLED array. In some examples larger LEDs can be employed. Although the illustrated examples show rectangular pixels arranged in a symmetric, regular array, the pixels and the array may have any suitable shape or arrangement, whether symmetric or asymmetric, regular or irregular. Multiple separate arrays of LEDs can be combined in any suitable arrangement in any applicable format to form a larger combined array or display.

One source of inefficiency of a wavelength-converted LED is that a fraction of the first output light that does not exit the LED 102 through a first LED surface and enter the wavelength converter 106. Some of that first output light might exit the LED 102, e.g., through LED sidewalls or a second LED surface opposite the first LED surface. Another source of inefficiency is propagation of second output light emitted by the wavelength converter 106 toward the LED 102, instead of exiting the wavelength-converting 106 structure to propagate away from the wavelength-converted LED 100.

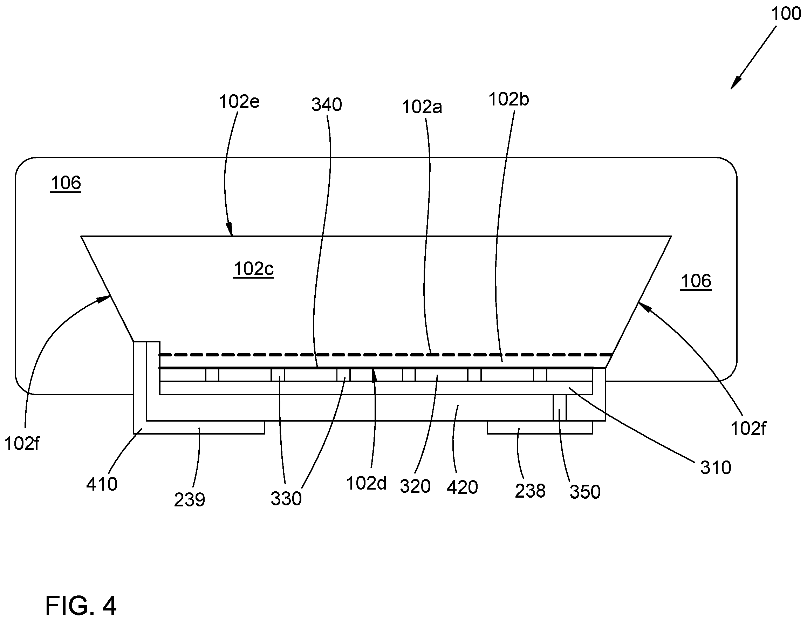

Schematic cross-sectional views of various examples of wavelength-converted LEDs 100 are shown in Figs. 4 through 11 in which various adaptations are implemented for increasing, e.g., the fraction of the first output light that exits the LED 102 and enters the wavelength converter 106, or the fraction of the second output light that exits the wavelength converter 106 and propagates away from the wavelength-converted LED 100.

Each wavelength-converted LED 100 of the present disclosure includes a semiconductor LED 102, a wavelength converter 106, first and second electrical contacts including corresponding contact pads 238 and 239, and one or more insulating layers.

The LED 102 has opposite first and second LED surfaces 102d and 102e, respectively, and LED sidewalls 102f connecting the first and second LED surfaces 102d/102e. The LED 102 includes one or more light-emitting active regions 102a, a first doped semiconductor layer 102b between the first LED surface 102d and the active region(s), and a second doped semiconductor layer 102c between second LED surface 102e and the active region(s) 102a. In many examples the doped layer 102b can be a p-doped layer and the doped layer 102c can be an n-doped layer. The LED 102 can include one or more doped or undoped III-V, II-VI, or Group IV semiconductor materials, or mixtures, alloys, or compounds thereof. The one or more light-emitting active regions 102a are arranged between the doped layers 102b/102c in any suitable way to emit first output light in a first output wavelength range, e.g., including one or more quantum wells or multi-quantum wells, quantum dots of any suitable size, composition, or structure, or one or more tunnel junctions of any suitable composition, thickness, or structure. The first output wavelength range can include UV light or visible light.

One or more wavelength-converted LEDs 100 can be positioned on the substrate 204 which can optionally include electrical traces or interconnects, or CMOS or other circuitry for connecting to the contact pads 238/239 and providing drive current to the LED 102, and can be formed from any suitable materials. LEDs 100 of the present disclosure are arranged with a flip chip contact geometry, as illustrated schematically in the example cross-sectional views of Figs. 4 through 11. In a flip chip geometry, small solder bumps are placed on the contact pads 238/239, the LED 100 is placed on the substrate 204 with the solder bumps on corresponding contact pads on the substrate 204, the solder bumps are heated to reflow to attach the LED 100 to the substrate 204 and to provide the necessary electrical connections. The attached LED 100 can be underfilled with electrically insulating material if needed or desired. The wavelength-converted flip chip LED 100 can be a single device (e.g., as in Fig. 1), or can be one device among many similarly arranged wavelength-converted LEDs 100 in an array 200 (e.g., as in Figs. 2A, 2B, or 3). In some examples individual LEDs 102 (pixels) in an array 200 of multiple LEDs can be individually addressable (i.e., selectively operable); in some examples the LEDs 102 can be addressable as part of a group or subset of the pixels in the array; in some examples the LEDs are not addressable.

The wavelength converter 106 is positioned on or facing at least the second LED surface 102e, and absorbs at least a portion of the first output light that enters the wavelength converter 106 and emits second output light in a second output wavelength range that is longer than the first output wavelength range. Any one or more suitable materials can be employed in the wavelength converter 106, such as phosphor particles of any suitable size or composition, or quantum dots of any suitable size, composition, or structure. Phosphor particles or quantum dots typically are dispersed, embedded, or coated in a suitable transparent medium (e.g., silicones, metal oxides/nitrides, or semiconductor oxides/nitrides). A wavelength converter 106 with quantum dots can be advantageously employed in LED arrays with spacing of less than 10 microns or device separation less than a few microns or sub-micron. In some examples the first output wavelength range includes one or more UV or visible wavelengths, the second output wavelength range includes one or more visible wavelengths, and the wavelength converter 106 is arranged to absorb substantially all of the entering first output light, so that overall output of the wavelength-converted light-emitting device 100 includes light in only the second wavelength range. In some other examples both the first and second output wavelength ranges include visible wavelengths, and the wavelength converter 106 is arranged to absorb only a portion of the entering first output light, so that overall output of the wavelength-converted light-emitting device 100 includes light in both the first and second wavelength ranges. In some examples the overall output of the wavelength-converted LED 100 can be white light having a selected color temperature or having specified color rendering properties.

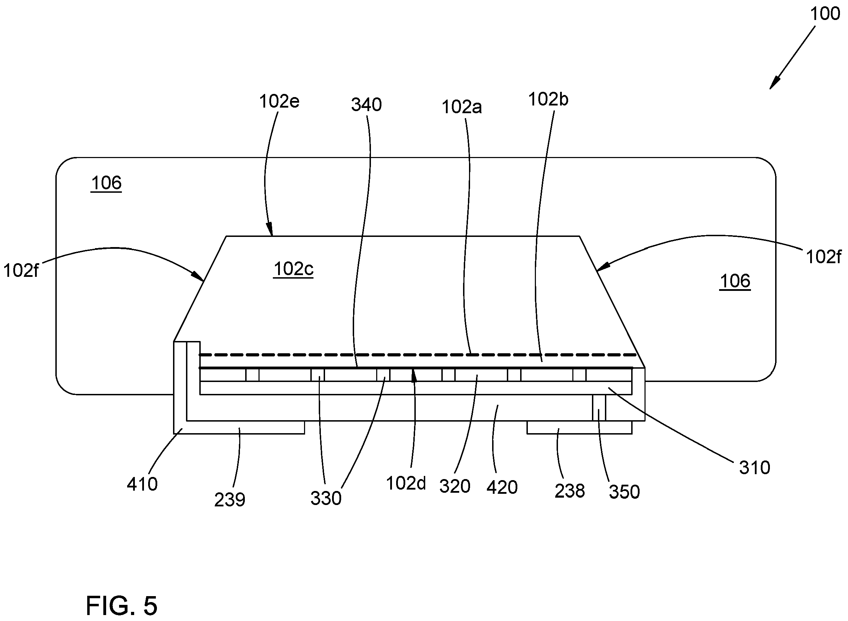

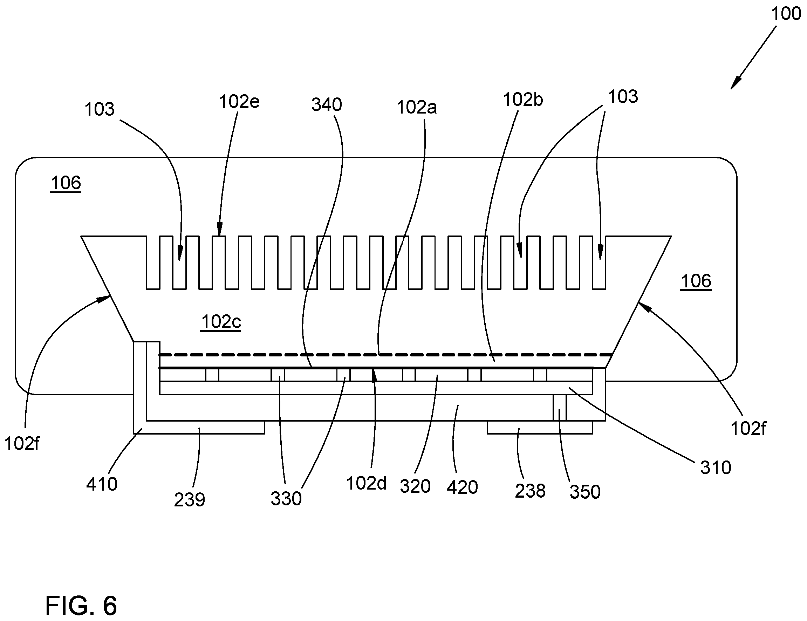

Figs. 4-6 illustrate schematically three examples among a first set of examples of a flip chip wavelength-converted LED 100. In those and similar examples the LED sidewalls 102f form an angle less than about 70° with either the first LED surface 102d (forming an upright truncated pyramid, as in Fig. 5) or the second LED surface 102e (forming an inverted truncated pyramid, as in Figs. 4 and 6). The wavelength converter 106 is positioned on the second LED surface 102e and the LED sidewalls 102f, so that any first output light exiting the LED 102 through those surfaces enters the wavelength converter 106. The angled sidewalls 102f increase the fraction of the first output light that exits the LED 102 and enters the wavelength converter 106. A first electrical contact is positioned on the first LED surface 102d and includes a metallic layer 310, a first electrically insulating layer 320 (e.g., a transparent dielectric layer) between the metallic layer 310 and the LED 102, and one or more electrically conductive vias 330 through the first insulating layer 320 that connect the metallic layer 310 to the first doped layer 102b. In some examples the first contact can include a transparent conductive oxide (TCO) layer 340 between the first insulating layer 320 and the LED 102 that is in direct contact with the first doped layer 102b; the one or more vias 330 connect the metallic layer 310 to the TCO layer 340 (and thus to the first doped layer 102b).

Any one or more suitable metals or metal alloys or mixtures can be employed for the metallic layer 310 (e.g., aluminum, silver, and so forth). Any one or more suitable transparent dielectric materials can be employed for the first insulating layer 320 (e.g., metal or semiconductor oxides or nitrides). Any one or more suitable materials can be employed for the TCO layer (e.g., indium tin oxide or indium zinc oxide). In some examples, the first insulating layer 320 includes only a single layer of transparent dielectric material (e.g., silicon oxide); in such examples the metallic layer 310 can act as a reflector for any first output light incident on the LED surface 102d, redirecting it toward the LED surface 102e and the wavelength converter 106. In some examples the first insulating layer 320 can include a multilayer dielectric reflector (e.g., a distributed Bragg reflector coating) that reflects any first output light incident on the LED surface 102d to redirect it toward the LED surface 102e and the wavelength converter 106.

A second electrically insulating layer 420 is positioned on the metallic layer 310 with the first contact between the second insulating layer 420 and the LED 102. Any one or more suitable dielectric materials can be employed, including those mentioned above for the first insulating layer 320. The insulating layers 320/420 can comprise the same material or can comprise different materials. A second electrical contact includes a second metallic layer 410 that is in direct electrical contact with the second doped layer 102c on an etched surface of the second doped layer 102c (e.g., as in Figs. 4-6) or a portion of the LED sidewalls 102f, and is electrically isolated, by the second insulating layer 420 from the active layer(s) 102a, the first doped layer 102b, and the first contact.

A first electrical contact pad 238 and a second electrical contact pad 239 are positioned on the second insulating layer 420 with the second insulating layer 420 between the contact pads 238/239 and the first metallic layer 310. One or more electrically conductive vias 350 through the second insulating layer 420 connect the first contact pad 238 to the first metallic layer 310. The second contact pad 239 is connected to the second metallic layer 410; in some instances, the second contact pad 239 is simply a suitably adapted areal region of the second metallic coating 410. The contact pads 238/239 are arranged to align with corresponding contact pads on a substrate on which the LED 100 is to be mounted (e.g., a circuit board or backplane, such as substrate 204 in Figs. 1 through 3). Before mounting the LED 100 onto the substrate, solder bumps (not shown) are deposited onto the contact pads 238/239. The LED is positioned with the solder bumps on the corresponding contact pads of the substrate and are heated to remelting, which attaches the LED 100 to the substrate and also establishes electrical connections for providing drive current to the LED 100.

In some examples arranged as in Figs. 4-6 additional structural adaptations can be employed to increase the fraction of the first output light that exits the LED 102 and enters the wavelength converter 106. In some examples the second LED surface 102c can include patterning, roughening, diffractive or scattering elements, a set of microlenses, or other structure(s) for more efficient coupling the first output light from the LED 102 into the wavelength converter 106. In some examples the thickness of the LED 102 (i.e., total thickness of the active layer(s) 102a and the doped layers 102b/102c) can be less than 5 microns, or less than 3 microns, or less than 2 microns, or about 1 micron. In some examples (as in Fig. 6) the second LED surface 102c can include a plurality of holes or depressions 103 in the second doped layer 102c that are at least partly filled with material of the wavelength converter 106. A wavelength converter 106 that includes quantum dots can be advantageously employed in such an example, because the small size of the quantum dots enables them to fill the holes or depressions 103. In the example of Fig. 6 the LED 102 forms an inverted truncated pyramid; a plurality of holes or depressions 103 filled with material of the wavelength converter 106 can also be provided in other examples (not shown) wherein the LED 102 forms an upright truncated pyramid.

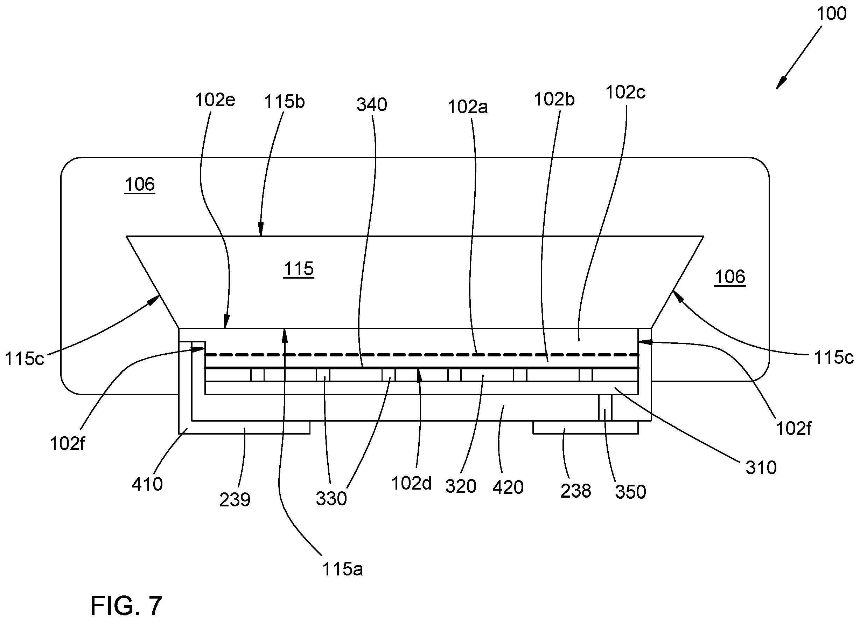

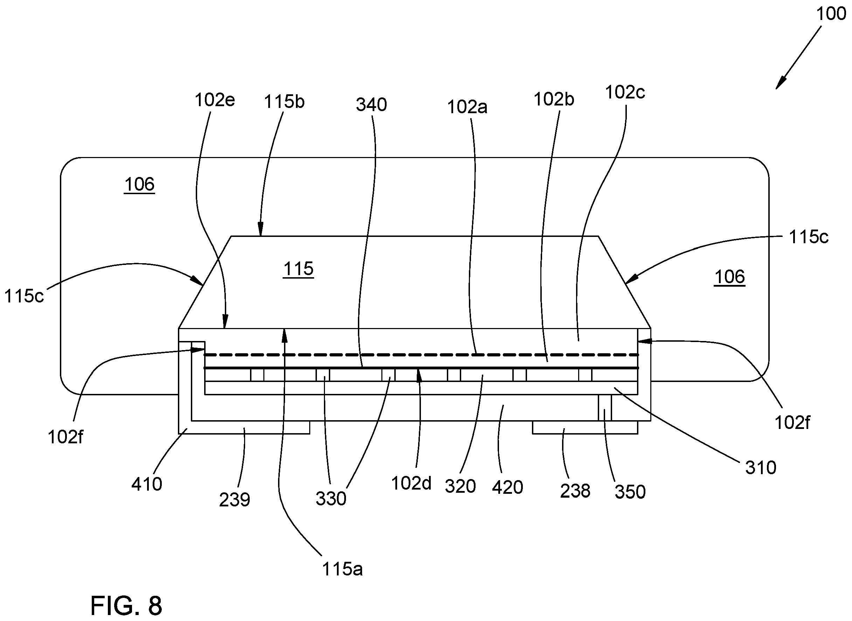

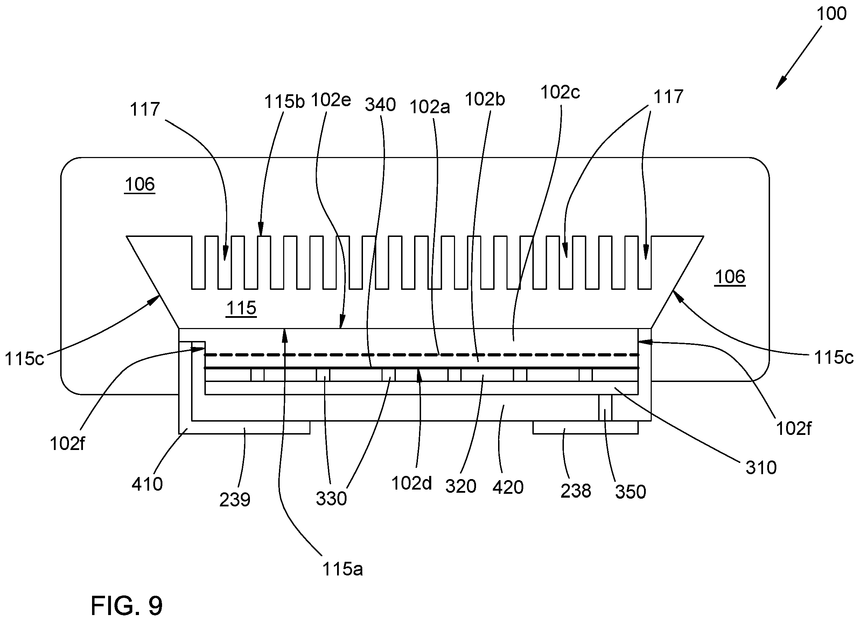

Figs. 7-9 illustrate schematically three examples among a second set of examples of a flip chip wavelength-converted LED 100. Examples of the second set resemble those of the first set (described above and illustrated schematically in Figs. 4-6), with the addition of a transparent dielectric medium 115 having opposite first and second dielectric surfaces 115a/115b and dielectric sidewalls 115c connecting the first and second dielectric surfaces 115a/115b. The first dielectric surface 115a is positioned against the second LED surface 102c, and the wavelength converter 106 is positioned on the second dielectric surface 115b, the dielectric sidewalls 115c, and the LED sidewalls 102f. First output light exiting the LED 102 through the second LED surface 102c enters the dielectric medium 115 and then exits the dielectric medium 115 to enter the wavelength converter 106. The dielectric sidewalls 115c can form an angle less than about 70° with either the first dielectric surface 115a (forming an upright truncated pyramid as in Fig. 8) or with the second dielectric surface 115b (forming an inverted truncated pyramid as in Figs. 7 and 9). The angled dielectric sidewalls 115c increase the fraction of the first output light that enters the wavelength converter 106. The dielectric medium 115 can include any one or more suitable transparent dielectric materials (e.g., metal or semiconductor oxides or nitrides; sapphire is commonly employed).

In some examples arranged as in Figs. 7-9 additional structural adaptations can be employed to increase the fraction of the first output light that exits the LED 102 and enters the wavelength converter 106. In some examples the second LED surface 102e can include patterning, roughening, diffractive or scattering elements, or other structure(s) for coupling the first output light from the LED 102 into the dielectric medium 115. In some examples the second dielectric surface 115b can include patterning, roughening, diffractive or scattering elements, a set of microlenses, or other structure(s) for coupling the first output light from the dielectric medium 115 into the wavelength converter 106. In some examples the thickness of the LED 102 can be less than 5 microns, less than 3 micron, less than 2 microns, or about 1 micron. In some examples the thickness of the dielectric medium 115 can be greater than 2X, 5X, 10X, 20X, 40X, or 60X the thickness of the LED 102. In some examples the second dielectric surface 115b can include a plurality of holes or depressions 117 in the dielectric medium 115 that are at least partly filled with material of the wavelength converter 106, as shown in Fig. 9 for a dielectric medium 115 that forms an inverted truncated pyramid. Such a plurality of holes or depressions 117 filled with material of the wavelength converter 106 can also be provided in other examples (not shown) with a dielectric medium 115 that forms an upright truncated pyramid.

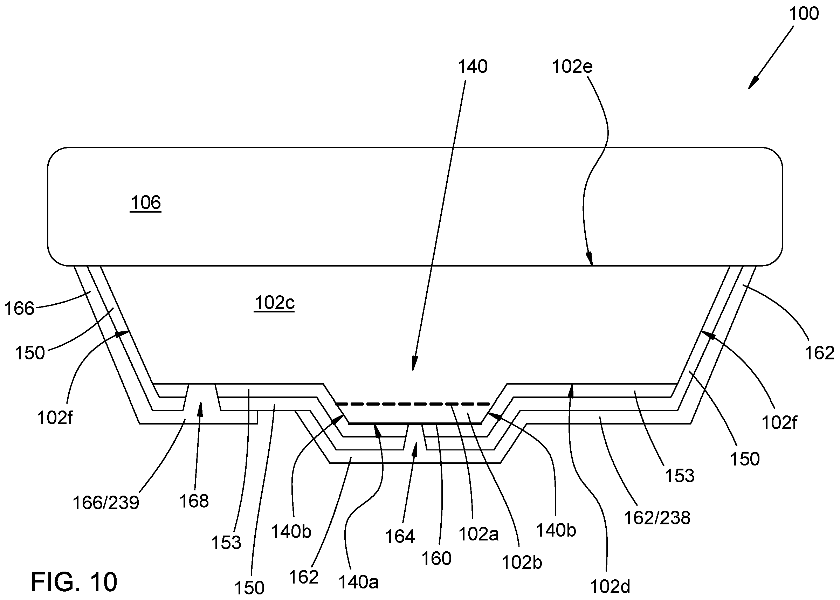

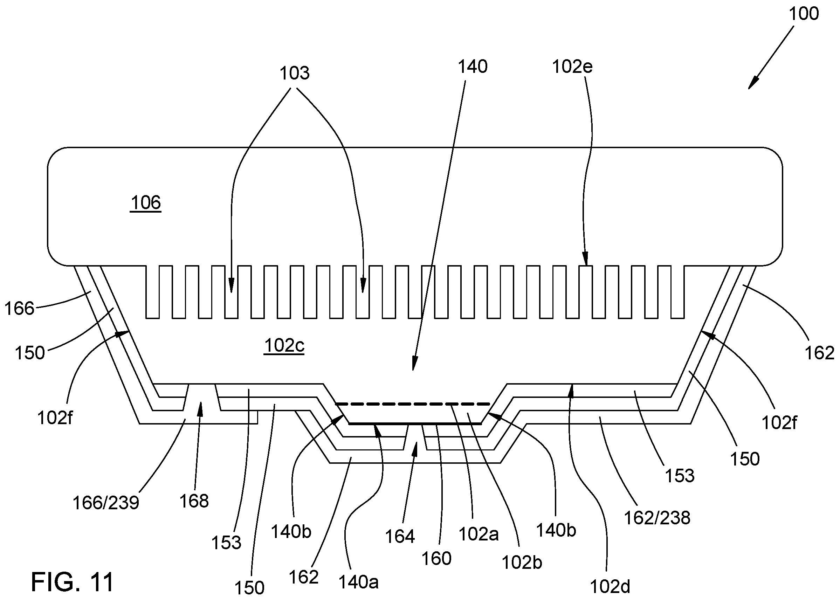

Figs. 10 and 11 illustrate schematically two examples among a third set of examples of a flip chip wavelength-converted LED 100. In those and similar examples the LED sidewalls 102f form an angle greater than about 110° with the first LED surface 102d (forming an inverted truncated pyramid, as in Figs. 10 and 11). The wavelength converter 106 is positioned on the second LED surface 102e, so that any first output light exiting the LED 102 through that surface enters the wavelength converter 106. The angled sidewalls 102f increase the fraction of the first output light that exits the LED 102 and enters the wavelength converter 106. The LED 102 includes a central mesa 140 protruding from the first LED surface 102b and has a mesa surface 140a and mesa sidewalls 140b connecting the mesa surface 140a to the first LED surface 102d, which surrounds the mesa 140. The mesa sidewalls 140b form an angle greater than about 110° with the mesa surface 140a, so that the mesa 140 resembles an inverted truncated pyramid. In some examples the angle between the LED sidewalls 102f and the first LED surface 102d differs from the angle between the mesa sidewalls 140b and the mesa surface 140a; in some other examples those angles are the same. The active region(s) 102a span the central mesa 140, and the first doped semiconductor layer 102b is between the mesa surface 140a and the active region(s) 102a. The second doped semiconductor layer 102c is between the second LED surface 102e and the active region(s) 102a (in the area of the mesa 140) and between the first and second LED surfaces 102d/102e (in areas surrounding the mesa 140).

A first electrically insulating layer 150 is positioned on the LED sidewalls 102f, the first LED surface 102d, the mesa sidewalls 140b, and the mesa surface 140a. A transparent conductive oxide (TCO) layer 160 is positioned between the first insulating layer 150 and the mesa surface 140 and is in direct contact with the first doped layer 102b. A first metallic layer 162 covers portions of the first insulating layer 150 and is connected to the TCO layer 160 by a first set of one or more electrically conductive vias 164 through the first insulating layer 150. A portion of the first metallic layer 162 is arranged in any suitable way to serve as the first contact pad 238. A second metallic layer 166 covers portions of the first insulating layer 150. The second metallic layer 166 is electrically isolated from the first metallic layer 162, and is connected to the second doped layer 102c at the first LED surface 102d by a second set of one or more electrically conductive vias 168 through the first insulating layer 150. A portion of the second metallic layer 166 is arranged in any suitable way to serve as the second contact pad 239.

In some examples arranged as in Figs. 10 and 11 additional structural adaptations can be employed to increase the fraction of the first output light that exits the LED 102 and enters the wavelength converter 106. In some examples the second LED surface 102e can include patterning, roughening, diffractive or scattering elements, a set of microlenses, or other structure(s) for coupling the first output light from the LED 102 into the wavelength converter 106. In some examples the thickness of the LED 102 can be less than 5 microns, less than 3 micron, less than 2 microns, or about 1 micron. In some examples the first and second metallic layers 162/166 extend onto the LED sidewalls 102f and can act as reflectors to redirect first output light incident on the LED sidewalls 102f toward the wavelength converter 106. In some examples the first dielectric layer 150 can include a multilayer reflector coating (e.g., a DBR coating) that is reflective over the first output wavelength range. In some examples a second electrically insulating layer 153 is positioned between the first insulating layer 150 and the LED 102; in such examples the vias 164/168 pass through both the first and second insulating layers 150/153. In some examples (e.g., as in Fig. 11) the second LED surface 102e can include a plurality of holes or depressions 103 in the second doped layer 102c that are at least partly filled with material of the wavelength converter 106.

Any one or more suitable metallic materials, including those discussed above, can be employed for the metallic layers 162/166. Any one or more suitable dielectric materials, including those discussed above, can be employed for the insulating layers 150/153. Any one or more suitable TCO materials, including those discussed above, can be employed for the TCO layer 160.

In addition to the preceding, the following example embodiments fall within the scope of the present disclosure or appended claims. Any given Example below that refers to multiple preceding Examples shall be understood to refer to only those preceding Examples with which the given Example is not inconsistent, and to exclude implicitly those preceding Examples with which the given Example is inconsistent.

Example 1. A wavelength-converted light-emitting device comprising: (a) a semiconductor light-emitting diode (LED) having opposite first and second LED surfaces and LED sidewalls connecting the first and second LED surfaces and forming an angle less than about 70° with either the first or the second LED surface, the LED including (i) one or more light-emitting active regions arranged so as to emit first output light in a first output wavelength range, (ii) a first doped semiconductor layer between the first LED surface and the one or more active regions, and (iii) a second doped semiconductor layer between second LED surface and the one or more active regions; (b) a wavelength converter, positioned on the second LED surface and the LED sidewalls, that absorbs at least a portion of the first output light that enters the wavelength converter and emits second output light in a second output wavelength range that is longer than the first output wavelength range; (c) a first electrical contact on the first LED surface, the first contact including (i) a first metallic layer, (ii) a first electrically insulating layer between the first metallic layer and LED, and (iii) one or more electrically conductive vias through the first insulating layer that connect the first metallic layer to the first doped layer; (d) a second electrically insulating layer on the first metallic layer with the first contact between the second insulating layer and the LED; (e) a second electrical contact that includes a second metallic layer (i) in direct electrical contact with the second doped layer and (ii) electrically isolated, by the second insulating layer, from the one or more active layers, the first doped layer, and the first contact; and (f) first and second electrical contact pads on the second insulating layer with the second insulating layer between the contact pads and the first metallic layer, (i) one or more electrically conductive vias through the second insulating layer connecting the first contact pad to the first metallic layer, and (ii) the second contact pad being connected to the second metallic layer.

Example 2. The device of Example 1 wherein the second LED surface includes patterning, roughening, scattering or diffractive elements, or a set of microlenses for coupling the first output light from the LED into the wavelength converter.

Example 3. The device of any one of Examples 1 or 2 wherein thickness of the LED is less than 5 microns, or less than 3 microns, or less than 2 microns, or about 1 micron.

Example 4. The device of any one of Examples 1 through 3 wherein the first electrical contact includes a transparent conductive oxide (TCO) layer between the first insulating layer and the LED and in direct contact with the first doped layer, the one or more vias connecting the first metallic layer to the TCO layer.

Example 5. The device of any one of Examples 1 through 4 wherein the first insulating layer includes a multilayer reflector coating that is reflective over the first output wavelength range.

Example 6. The device of any one of Examples 1 through 5 wherein the second LED surface includes a plurality of holes or depressions in the second doped layer at least partly filled with material of the wavelength converter.

Example 7. A wavelength-converted light-emitting device comprising: (a) a semiconductor light-emitting diode (LED) having opposite first and second LED surfaces and LED sidewalls connecting the first and second LED surfaces, the LED including (i) one or more light-emitting active regions arranged so as to emit first output light in a first output wavelength range, (ii) a first doped semiconductor layer between the first LED surface and the one or more active regions, and (iii) a second doped semiconductor layer between second LED surface and the one or more active regions; (b) a solid transparent dielectric medium having opposite first and second dielectric surfaces and dielectric sidewalls connecting the first and second dielectric surfaces and forming an angle less than about 70° with either the first or the second dielectric surface, the first dielectric surface being positioned against the second LED surface; (c) a wavelength converter, positioned on the second dielectric surface, the dielectric sidewalls, and the LED sidewalls, that absorbs at least a portion of the first output light that enters the wavelength converter and emits second output light in a second output wavelength range that is longer than the first output wavelength range; (d) a first electrical contact on the first LED surface, the first contact including (i) a first metallic layer, (ii) a first electrically insulating layer between the first metallic layer and the LED, and (iii) one or more electrically conductive vias through the first insulating layer that connect the first metallic layer to the first doped layer; (e) a second electrically insulating layer on the first metallic layer with the first contact between the second insulating layer and the LED; (f)
a second electrical contact that includes a second metallic layer (i) in direct electrical contact with the second doped layer and (ii) electrically isolated, by the second insulating layer, from the one or more active layers, the first doped layer, and the first contact; and (g) first and second electrical contact pads on the second insulating layer with the second insulating layer between the contact pads and the first metallic layer, (i) one or more electrically conductive vias through the second insulating layer connecting the first contact pad to the first metallic layer, and (ii) the second contact pad being connected to the second metallic layer.

Example 8. The device of Example 7 wherein thickness of the dielectric medium is greater than 2X, 5X, 10X, 20X, 40X, or 60X thickness of the LED.

Example 9. The device of any one of Examples 7 or 8 wherein (i) the second LED surface includes patterning, roughening, or scattering or diffractive elements for coupling the first output light from the LED into the dielectric medium, or (ii) the second dielectric surface includes patterning, roughening, scattering or diffractive elements, or a set of microlenses for coupling the first output light from the dielectric medium into the wavelength converter.

Example 10. The device of any one of Examples 7 through 9 wherein thickness of the LED is less than 5 microns, or less than 3 microns, or less than 2 microns, or about 1 micron.

Example 11. The device of any one of Examples 7 through 10 wherein the first electrical contact includes a transparent conductive oxide (TCO) layer between the first insulating layer and the LED and in direct contact with the first doped layer, the one or more vias connecting the first metallic layer to the TCO layer.

Example 12. The device of any one of Examples 7 through 11 wherein the first insulating layer includes a multilayer reflector coating that is reflective over the first output wavelength range.

Example 13. The device of any one of Examples 7 through 12 wherein the second dielectric surface includes a plurality of holes or depressions in the dielectric medium at least partly filled with material of the wavelength converter.

Example 14. A wavelength-converted light-emitting device comprising: (a) a semiconductor light-emitting diode (LED) having opposite first and second LED surfaces and LED sidewalls connecting the first and second LED surfaces and forming an angle greater than about 110° with the first LED surface, the LED including (i) a central mesa protruding from the first LED surface and having a mesa surface and mesa sidewalls connecting the mesa surface to the first LED surface and forming an angle greater than about 110° with the mesa surface, (ii) one or more light-emitting active regions spanning the central mesa and arranged so as to emit first output light in a first output wavelength range, (iii) a first doped semiconductor layer between the mesa surface and the one or more active regions, and (iv) a second doped semiconductor layer between second LED surface and the one or more active regions and between the first and second LED surfaces; (b) a wavelength converter, positioned on the second LED surface, that absorbs at least a portion of the first output light that enters the wavelength converter and emits second output light in a second output wavelength range that is longer than the first output wavelength range; (c) a first electrically insulating layer on the LED sidewalls, the first LED surface, the mesa sidewalls, and the mesa surface; (d) a transparent conductive oxide (TCO) layer between the first insulating layer and the mesa surface and in direct contact with the first doped layer; (e) a first metallic layer on portions of the first insulating layer and connected to the TCO layer by a first set of one or more electrically conductive vias through the first insulating layer, a portion of the first metallic layer being arranged as a first contact pad; and (f) a second metallic layer on portions of the first insulating layer, electrically isolated from the first metallic layer, and connected to the second doped layer at the first LED surface by a second set of one or more electrically conductive vias through the first insulating layer, a portion of the second metallic layer being arranged as a second contact pad.

Example 15. The device of Example 14 wherein the second LED surface includes patterning, roughening, scattering or diffractive elements, or a set of microlenses for coupling the first output light from the LED into the wavelength converter.

Example 16. The device of any one of Examples 14 or 15 wherein thickness of the LED is less than 5 microns, or less than 3 microns, or less than 2 microns, or about 1 micron.

Example 17. The device of any one of Examples 14 through 16 wherein the first and second metallic layers extend onto the LED sidewalls.

Example 18. The device of any one of Examples 14 through 17 wherein the first insulating layer includes a multilayer reflector coating that is reflective over the first output wavelength range.

Example 19. The device of any one of Examples 14 through 18 further comprising a second electrically insulating layer between the first insulating layer and the LED.

Example 20. The device of any one of Examples 14 through 19 wherein the second LED surface includes a plurality of holes or depressions in the second doped layer at least partly filled with material of the wavelength converter.

Example 21. The device of any one of Examples 14 through 20 wherein the angle between the LED sidewalls and the first LED surface differs from the angle between the mesa sidewalls and the mesa surface.

Example 22. The light-emitting device of any one of Examples 1 through 21 wherein either: (i) the first output wavelength range includes one or more UV or visible wavelengths, the second output wavelength range includes one or more visible wavelengths, and the wavelength converter is arranged to absorb substantially all of the entering first output light, so that overall output of the light-emitting device includes light in only the second wavelength range; or (ii) both the first and second output wavelength ranges include visible wavelengths, and the wavelength converter is arranged to absorb only a portion of the entering first output light, so that overall output of the light-emitting device includes light in both the first and second wavelength ranges.

Example 23. The light-emitting device of any one of Examples 1 through 22 wherein (i) the LED includes one or more doped or undoped III-V, II-VI, or Group IV semiconductor materials, or mixtures, alloys, or compounds thereof, (ii) the first doped layer is a p-doped layer and the second doped layer is an n-doped layer, or (iii) the one or more active regions include quantum dots, one or more quantum wells, one or more multi-quantum wells, or one or more tunnel junctions.

Example 24. The light-emitting device of any one of Examples 1 through 23 further comprising a light-emitting array that includes the light-emitting device and multiple additional similarly arranged light-emitting devices.

Example 25. The light emitting array of Example 24 wherein: (i) spacing of the light-emitting devices of the array is less than 1 millimeter, less than 500 microns, less than 200 microns, less than 100 microns, less than 50 microns, less than 20 microns, less than 10 microns, or less than 5 microns; or (ii) separation between light-emitting devices of the array is less than 200 microns, less than 100 microns, less than 50 microns, less than 20 microns, less than 10 microns, or less than 5 microns.

This disclosure is illustrative and not limiting. Further modifications will be apparent to one skilled in the art in light of this disclosure and are intended to fall within the scope of the present disclosure or appended claims. It is intended that equivalents of the disclosed example embodiments and methods, or modifications thereof, shall fall within the scope of the present disclosure or appended claims.

In the foregoing Detailed Description, various features may be grouped together in several example embodiments for the purpose of streamlining the disclosure. This method of disclosure is not to be interpreted as reflecting an intention that any claimed embodiment requires more features than are expressly recited in the corresponding claim. Rather, as the appended claims reflect, inventive subject matter may lie in less than all features of a single disclosed example embodiment. Therefore, the present disclosure shall be construed as implicitly disclosing any embodiment having any suitable subset of one or more features - which features are shown, described, or claimed in the present application - including those subsets that may not be explicitly disclosed herein. A "suitable" subset of features includes only features that are neither incompatible nor mutually exclusive with respect to any other feature of that subset. Accordingly, the appended claims are hereby incorporated in their entirety into the Detailed Description, with each claim standing on its own as a separate disclosed embodiment. In addition, each of the appended dependent claims shall be interpreted, only for purposes of disclosure by said incorporation of the claims into the Detailed Description, as if written in multiple dependent form and dependent upon all preceding claims with which it is not inconsistent. It should be further noted that the cumulative scope of the appended claims can, but does not necessarily, encompass the whole of the subject matter disclosed in the present application.

The following interpretations shall apply for purposes of the present disclosure and appended claims. The words "comprising," "including," "having," and variants thereof, wherever they appear, shall be construed as open ended terminology, with the same meaning as if a phrase such as "at least" were appended after each instance thereof, unless explicitly stated otherwise. The article "a" shall be interpreted as "one or more" unless "only one," "a single," or other similar limitation is stated explicitly or is implicit in the particular context; similarly, the article "the" shall be interpreted as "one or more of the" unless "only one of the," "a single one of the," or other similar limitation is stated explicitly or is implicit in the particular context. The conjunction "or" is to be construed inclusively unless: (i) it is explicitly stated otherwise, e.g., by use of "either... or," "only one of," or similar language; or (ii) two or more of the listed alternatives are understood or disclosed (implicitly or explicitly) to be incompatible or mutually exclusive within the particular context. In that latter case, "or" would be understood to encompass only those combinations involving non-mutually-exclusive alternatives. In one example, each of "a dog or a cat," "one or more of a dog or a cat," and "one or more dogs or cats" would be interpreted as one or more dogs without any cats, or one or more cats without any dogs, or one or more of each.

For purposes of the present disclosure or appended claims, when a numerical quantity is recited (with or without terms such as "about," "about equal to," "substantially equal to," "greater than about," "less than about," and so forth), standard conventions pertaining to measurement precision, rounding error, and significant digits shall apply, unless a differing interpretation is explicitly set forth, or if a differing interpretation is implicit or inherent (e.g., some small integer quantities). For null quantities described by phrases such as "equal to zero," "absent," "eliminated," "negligible," "prevented," and so forth (with or without terms such as "about," "substantially," and so forth), each such phrase shall denote the case wherein the quantity in question has been reduced or diminished to such an extent that, for practical purposes in the context of the intended operation or use of the disclosed or claimed apparatus or method, the overall behavior or performance of the apparatus or method does not differ from that which would have occurred had the null quantity in fact been completely removed, exactly equal to zero, or otherwise exactly nulled. Terms such as "parallel," "perpendicular," "orthogonal," "flush," "aligned," and so forth shall be similarly interpreted (with or without terms such as "about," "substantially," and so forth).

For purposes of the present disclosure and appended claims, any labelling of elements, steps, limitations, or other portions of an embodiment, example, or claim (e.g., first, second, third, etc., (a), (b), (c), etc., or (i), (ii), (iii), etc.) is only for purposes of clarity, and shall not be construed as implying any sort of ordering or precedence of the portions so labelled. If any such ordering or precedence is intended, it will be explicitly recited in the embodiment, example, or claim or, in some instances, it will be implicit or inherent based on the specific content of the embodiment, example, or claim. In the appended claims, if the provisions of 35 USC § 112(f) are desired to be invoked in an apparatus claim, then the word "means" will appear in that apparatus claim. If those provisions are desired to be invoked in a method claim, the words "a step for" will appear in that method claim. Conversely, if the words "means" or "a step for" do not appear in a claim, then the provisions of 35 USC § 112(f) are not intended to be invoked for that claim.

If any one or more disclosures are incorporated herein by reference and such incorporated disclosures conflict in part or whole with, or differ in scope from, the present disclosure, then to the extent of conflict, broader disclosure, or broader definition of terms, the present disclosure controls. If such incorporated disclosures conflict in part or whole with one another, then to the extent of conflict, the later-dated disclosure controls.

The Abstract is provided as required as an aid to those searching for specific subject matter within the patent literature. However, the Abstract is not intended to imply that any elements, features, or limitations recited therein are necessarily encompassed by any particular claim. The scope of subject matter encompassed by each claim shall be determined by the recitation of only that claim.

## Claims

1. A wavelength-converted light-emitting device comprising:
(a) a semiconductor light-emitting diode (LED) having opposite first and second LED surfaces and LED sidewalls connecting the first and second LED surfaces and forming an angle less than about 70° with either the first or the second LED surface, the LED including (i) one or more light-emitting active regions arranged so as to emit first output light in a first output wavelength range, (ii) a first doped semiconductor layer between the first LED surface and the one or more active regions, and (iii) a second doped semiconductor layer between second LED surface and the one or more active regions;
(b) a wavelength converter, positioned on the second LED surface and the LED sidewalls, that absorbs at least a portion of the first output light that enters the wavelength converter and emits second output light in a second output wavelength range that is longer than the first output wavelength range;
(c) a first electrical contact on the first LED surface, the first contact including (i) a first metallic layer, (ii) a first electrically insulating layer between the first metallic layer and LED, and (iii) one or more electrically conductive vias through the first insulating layer that connect the first metallic layer to the first doped layer;
(d) a second electrically insulating layer on the first metallic layer with the first contact between the second insulating layer and the LED;
(e) a second electrical contact that includes a second metallic layer (i) in direct electrical contact with the second doped layer and (ii) electrically isolated, by the second insulating layer, from the one or more active layers, the first doped layer, and the first contact; and
(f) first and second electrical contact pads on the second insulating layer with the second insulating layer between the contact pads and the first metallic layer, (i) one or more electrically conductive vias through the second insulating layer connecting the first contact pad to the first metallic layer, and (ii) the second contact pad being connected to the second metallic layer.

2. A wavelength-converted light-emitting device comprising:
(a) a semiconductor light-emitting diode (LED) having opposite first and second LED surfaces and LED sidewalls connecting the first and second LED surfaces, the LED including (i) one or more light-emitting active regions arranged so as to emit first output light in a first output wavelength range, (ii) a first doped semiconductor layer between the first LED surface and the one or more active regions, and (iii) a second doped semiconductor layer between second LED surface and the one or more active regions;
(b) a solid transparent dielectric medium having opposite first and second dielectric surfaces and dielectric sidewalls connecting the first and second dielectric surfaces and forming an angle less than about 70° with either the first or the second dielectric surface, the first dielectric surface being positioned against the second LED surface;
(c) a wavelength converter, positioned on the second dielectric surface, the dielectric sidewalls, and the LED sidewalls, that absorbs at least a portion of the first output light that enters the wavelength converter and emits second output light in a second output wavelength range that is longer than the first output wavelength range;
(d) a first electrical contact on the first LED surface, the first contact including (i) a first metallic layer, (ii) a first electrically insulating layer between the first metallic layer and the LED, and (iii) one or more electrically conductive vias through the first insulating layer that connect the first metallic layer to the first doped layer;
(e) a second electrically insulating layer on the first metallic layer with the first contact between the second insulating layer and the LED;
(f) a second electrical contact that includes a second metallic layer (i) in direct electrical contact with the second doped layer and (ii) electrically isolated, by the second insulating layer, from the one or more active layers, the first doped layer, and the first contact; and
(g) first and second electrical contact pads on the second insulating layer with the second insulating layer between the contact pads and the first metallic layer, (i) one or more electrically conductive vias through the second insulating layer connecting the first contact pad to the first metallic layer, and (ii) the second contact pad being connected to the second metallic layer.

3. The device of claim 2 wherein thickness of the dielectric medium is greater than 2X thickness of the LED.

4. The device of any one of claims 1 through 3 wherein the first electrical contact includes a transparent conductive oxide (TCO) layer between the first insulating layer and the LED and in direct contact with the first doped layer, the one or more vias connecting the first metallic layer to the TCO layer.

5. A wavelength-converted light-emitting device comprising:
(a) a semiconductor light-emitting diode (LED) having opposite first and second LED surfaces and LED sidewalls connecting the first and second LED surfaces and forming an angle greater than about 110° with the first LED surface, the LED including (i) a central mesa protruding from the first LED surface and having a mesa surface and mesa sidewalls connecting the mesa surface to the first LED surface and forming an angle greater than about 110° with the mesa surface, (ii) one or more light-emitting active regions spanning the central mesa and arranged so as to emit first output light in a first output wavelength range, (iii) a first doped semiconductor layer between the mesa surface and the one or more active regions, and (iv) a second doped semiconductor layer between second LED surface and the one or more active regions and between the first and second LED surfaces;
(b) a wavelength converter, positioned on the second LED surface, that absorbs at least a portion of the first output light that enters the wavelength converter and emits second output light in a second output wavelength range that is longer than the first output wavelength range;
(c) a first electrically insulating layer on the LED sidewalls, the first LED surface, the mesa sidewalls, and the mesa surface;
(d) a transparent conductive oxide (TCO) layer between the first insulating layer and the mesa surface and in direct contact with the first doped layer;
(e) a first metallic layer on portions of the first insulating layer and connected to the TCO layer by a first set of one or more electrically conductive vias through the first insulating layer, a portion of the first metallic layer being arranged as a first contact pad; and
(f) a second metallic layer on portions of the first insulating layer, electrically isolated from the first metallic layer, and connected to the second doped layer at the first LED surface by a second set of one or more electrically conductive vias through the first insulating layer, a portion of the second metallic layer being arranged as a second contact pad.

6. The device of claim 5 wherein the angle between the LED sidewalls and the first LED surface differs from the angle between the mesa sidewalls and the mesa surface.

7. The device of any one of claims 5 or 6 further comprising a second electrically insulating layer between the first insulating layer and the LED.

8. The device of any one of claims 1 through 7 wherein (i) the second LED surface includes patterning, roughening, scattering or diffractive elements, or a set of microlenses for coupling the first output light from the LED into the wavelength converter or the dielectric medium, or (ii) the second dielectric surface includes patterning, roughening, scattering or diffractive elements, or a set of microlenses for coupling the first output light from the dielectric medium into the wavelength converter.

9. The device of any one of claims 1 through 8 wherein thickness of the LED is less than 5 microns.

10. The device of any one of claims 1 through 9 wherein the first and second metallic layers extend onto the LED sidewalls.

11. The device of any one of claims 1 through 10 wherein the first insulating layer includes a multilayer reflector coating that is reflective over the first output wavelength range.

12. The device of any one of claims 1 through 11 wherein the second LED surface or the second dielectric surface includes a plurality of holes or depressions in the second doped layer at least partly filled with material of the wavelength converter.

13. The light-emitting device of any one of claims 1 through 12 wherein (i) the LED includes one or more doped or undoped III-V, II-VI, or Group IV semiconductor materials, or mixtures, alloys, or compounds thereof, (ii) the first doped layer is a p-doped layer and the second doped layer is an n-doped layer, or (iii) the one or more active regions include quantum dots, one or more quantum wells, one or more multi-quantum wells, or one or more tunnel junctions.

14. The light-emitting device of any one or claims 1 through 13 further comprising a light-emitting array that includes the light-emitting device and multiple additional similarly arranged light-emitting devices.
